# NEUE EUROPÄISCHE PATENTSCHRIFT

(11) **EP 1 601 231 B2**
(45) Veröffentlichungstag und Bekanntmachung des Hinweises auf die Entscheidung über den Einspruch: **20.03.2019**
(45) Hinweis auf die Patenterteilung: 29.06.2011
(21) Anmeldenummer: 05104214.1
(22) Anmeldetag: 18.05.2005
(51) Int. Cl.: H01M 10/48, G01R 31/36, H04R 25/00

(54) **Hörhilfegerät oder Hörgerätesystem mit akustischer Batterieanzeige**
Hearing aid or hearing aid system with acoustic battery indication
Prothèse auditive ou système de prothèse auditive avec signalisation d'état de charge acoustique d'une batterie

(30) Priorität: 21.05.2004 DE 102004025123
(43) Veröffentlichungstag der Anmeldung: 30.11.2005
(73) Patentinhaber: Sivantos GmbH, 91058 Erlangen (DE)
(72) Erfinder: Barthel, Roland, 91054 Erlangen (DE); Beimel, Bernd, 91054 Erlangen (DE); Eggers, Joachim, 72072 Tübingen (DE); Fröhlich, Matthias, 91056 Erlangen (DE)
(74) Vertreter: FDST Patentanwälte

(56) Entgegenhaltungen:
- EP-A- 0 425 044
- DE-A1- 10 012 964
- DE-A1- 10 041 727
- DE-A1- 10 114 015
- DE-A1- 10 114 015
- DE-A1- 19 825 750
- DE-C1- 19 915 846
- JP-A- H0 918 997
- US-A- 4 049 930
- US-A1- 2002 159 613
- US-A1- 2002 159 613
- US-B1- 6 310 556
- US-B1- 6 463 305

## Beschreibung

Die Erfindung betrifft ein Hörhilfegerät oder Hörgerätesystem gemäß dem Oberbegriff des Patentanspruches 1 oder 2. Ferner betrifft die Erfindung ein Hörgerätesystem gemäß dem Oberbegriff des Patentanspruches 19.

Hörhilfegeräte oder Hörgerätesysteme werden gewöhnlich mit einer netzunabhängigen Spannungsquelle, also einer Batterie oder einem Akku, betrieben. Aus der US 2002/0159613 A1 ist ein Hörgerät mit einer Spannungsquelle bekannt, bei dem beim Unterschreiten der Ausgangsspannung der Spannungsquelle ein akustisches Signal abgegeben wird zur Warnung des Hörgeräteträgers vor einer zur Neige gehenden Spannungsquelle.

Nachteilig bei dem bekannten Hörgerät ist, dass die Warnung vor einer zur Neige gehenden Spannungsquelle eventuell so spät erfolgt, dass unter bestimmten Umständen ein rechtzeitiger Austausch nicht mehr möglich ist.

Aus der DE 198 25 750 A1 ist ein Verfahren zum Prüfen des Ladezustandes der Spannungsquelle eines Hörhilfegerätes bekannt. Das mit einem Signalempfänger, einem Verstärker- und Übertragungsteil, einem Ausgangswandler und einer Spannungsquelle ausgestattete Hörhilfegerät weist ein Schaltmittel zum Aktivieren einer Prüfschaltung auf, die die Spannung an der Spannungsquelle erfasst und bei anliegender Normalspannung ein elektrisches Signal generiert, das der Ausgangswandler in ein Tonsignal wandelt, welches Aufschluss über den Ladezustand der Spannungsquelle gibt.

Aufgabe der vorliegenden Erfindung ist es daher, die Information bezüglich des Ladezustandes der Spannungsquelle zu verbessern.

Diese Aufgabe wird gelöst durch ein Hörhilfegerät mit den Merkmalen gemäß Anspruch 1. Ferner wird die Aufgabe gelöst durch ein Hörgerätesystem mit den Merkmalen gemäß Anspruch 9.

Das Hörhilfegerät oder Hörgerätesystem gemäß der Erfindung umfasst Mittel zur Bedienung des Hörhilfegerätes oder Hörgerätesystems. Diese können beispielsweise als manuell betätigbare Bedienelemente, z.B. Taster, ausgebildet sein. Darüber hinaus kann auch eine Fernbedienung zur Bedienung des Hörhilfegerätes vorhanden sein. Bei dem Hörhilfegerät gemäß der Erfindung können neben manuell betätigbaren Bedienelementen aber auch andere Mittel zur Bedienung vorsehen sein, z.B. ein Sprachdecoder zum Erkennen gesprochener Codewörter, die bestimmte Bedienfunktionen auslösen.

Das Hörhilfegerät gemäß der Erfindung umfasst Mittel zum Ermitteln des Ladezustandes der Spannungsquelle. Die Ermittlung des Ladezustandes erfolgt vorzugsweise durch eine Messung der aktuellen Ausgangsspannung der Spannungsquelle. Es können jedoch auch andere, den Ladungszustand kennzeichnende physikalische Größen ermittelt und ausgewertet werden, wie z.B. der Kurzschlussstrom, die Kapazität, die Induktivität usw. Insbesondere können auch mehrere dieser Größen gemeinsam ausgewertet werden. Weiterhin kann die Ermittlung des Ladezustandes auch unter Berücksichtigung der Zeitdauer erfolgen, in der sich die Spannungsquelle in dem Hörhilfegerät befindet und insbesondere unter Berücksichtigung der Zeitdauer, in der das Hörhilfegerät dabei eingeschaltet war.

Bei der Erfindung ist vorgesehen, dass eine Information bezüglich der zu erwartenden Restlaufzeit mit der aktuell verwendeten Spannungsquelle und unter den gegebenen Hörgeräteeinstellungen erfolgt. Hierzu ist das Hörhilfegerät gemäß der Erfindung mit Mitteln zum Bestimmen der zu erwartenden Restlaufzeit ausgestattet. Auch diese berücksichtigen vorzugsweise die Ausgangsspannung, den Ausgangsstrom oder die Verwendungsdauer der aktuellen Spannungsquelle.

Bei der Erfindung ist vorgesehen, dass das Hörhilfegerät Mittel zur Eingabe von Daten zur Kennzeichnung der verwendeten Spannungsquelle umfasst und die Ermittlung der zu erwartenden Restlaufzeit unter Berücksichtigung dieser Daten erfolgt. Diese Daten können beispielsweise den Typ der verwendeten Spannungsquelle, z.B. Zink-Luft-Batterie oder Lithium-Ionen-Akku oder technische Angaben, wie Nennspannung oder Speicherkapazität, kennzeichnen.

Ein zur Erfindung nicht gehörendes Beispiel sieht vor, dass Daten zur Kennzeichnung der verwendeten Spannungsquelle automatisch im Hörhilfegerät generiert werden. Das Hörhilfegerät ist hierzu mit Mitteln zum Erzeugen derartiger Daten ausgestattet. So können beispielsweise die Leerlaufspannung oder der Kurzschlussstrom einer neu in das Hörhilfegerät eingesetzten Spannungsquelle Aufschluss über diese geben. Darüber hinaus ist es auch möglich, dass die Spannungsquelle selbst mit Kennzeichnungsmitteln versehen ist, die durch das Hörhilfegerät erfassbar sind. Diese Kennzeichnungsmittel können sowohl mechanischer als auch elektrischer Natur sein.

Die Bedienung des Hörhilfegerätes zum Abrufen der Information bezüglich. der Restlaufzeit erfolgt vorzugsweise durch Betätigung eines am Hörhilfegerät angeordneten Bedienelements. Um den zur Bedienung des Hörhilfegerätes erforderlichen Platz am Hörhilfegerät möglichst klein zu halten, kann dieses Bedienelement auch mit weiteren Funktionen, z.B. der Programmumschaltung, belegt sein. Darüber hinaus ist es auch möglich, dass das Bedienelement an einer Fernbedienung angeordnet ist. Dadurch wird insbesondere eine für Dritte nicht erkennbare Abfrage der Restlaufzeit ermöglicht. Die Betätigung des Bedienelementes an der Fernbedienung kann nämlich verdeckt, z.B. in der Hosentasche, erfolgen und auch die Ausgabe des akustischen Signals zur Information bezüglich der Restlaufzeit sind für einen Außenstehenden nicht erkennbar.

Eine andere Möglichkeit besteht darin, die Information bezüglich der Restlaufzeit durch ein an das Hörhilfegerät abgegebenes akustisches Signal, z.B. ein gesprochenes Codewort, auszulösen. Auch dadurch wird die Bedienung des Hörhilfegerätes wesentlich vereinfacht.

Eine weitere vorteilhafte Weiterbildung der Erfindung besteht darin, die Information bezüglich der Restlaufzeit mit der Bedienung eines Ein-/Ausschalters zu verknüpfen. Dann wird der Hörgeräteträger bei jedem Ein- oder Ausschalten des Hörhilfegerätes automatisch an die zu erwartende Restlaufzeit erinnert.

Bei einer Ausführungsform der Erfindung ist vorgesehen, dass das von dem Ausgangswandler abgegebene akustische Signal ein Ton und insbesondere ein Sinuston mit steigender oder fallender Frequenz ist. Hierzu ist eine Schwelle eingestellt oder durch Programmieren des Hörgerätes einstellbar, so dass beim Überschreiten der Restlaufzeit dieser Schwelle der Ton mit steigender Frequenz ausgegeben wird und beim Unterschreiten dieser Schwelle der Ton mit fallender Frequenz ausgegeben wird. Die Zeitdauer sowie die Veränderung der Frequenz des ausgegebenen Tons können als Maß für die Abweichung der Restlaufzeit von dem Schwellenwert dienen. Dadurch wird auf einfache Weise eine verhältnismäßig genaue Abschätzung der zu erwartenden Restlaufzeit ermöglicht.

Eine komfortablere Ausführungsform der Erfindung sieht die Information bezüglich der Restlaufzeit durch Sprachausgabe vor. Hierdurch kann eine sehr genaue Information über die Restlaufzeit, beispielsweise durch Angabe in Stunden und Minuten, erfolgen.

Hörgeräteträger sind häufig binaural, d.h. an beiden Ohren mit jeweils einem Hörhilfegerät versorgt. Die Information bezüglich der Restlaufzeit erfolgt dann vorzugsweise derart, dass eine einmalige Bedienung genügt, beispielsweise ein einmalig gesprochenes Codewort oder eine einmalige Betätigung der Fernbedienung, und die beiden Hörhilfegeräte so gesteuert sind, dass die jeweilige Information bezüglich der Restlaufzeit nacheinander ausgegeben wird. Der Hörgeräteträger ist dann in einfacher Weise bestens über den Gesamtzustand des Hörgerätesystems informiert.

Die Erfindung wird nachfolgend anhand von Ausführungsbeispielen erläutert. Es zeigen:
- Figur 1: ein Hörhilfegerät gemäß der Erfindung im Blockschaltbild,
- Figur 2: eine weitere Ausführungsform eines Hörhilfegerätes gemäß der Erfindung im Blockschaltbild,
- Figur 3: ein Hörgerätesystem mit zwei Hörhilfegeräten und einer Fernbedienung.

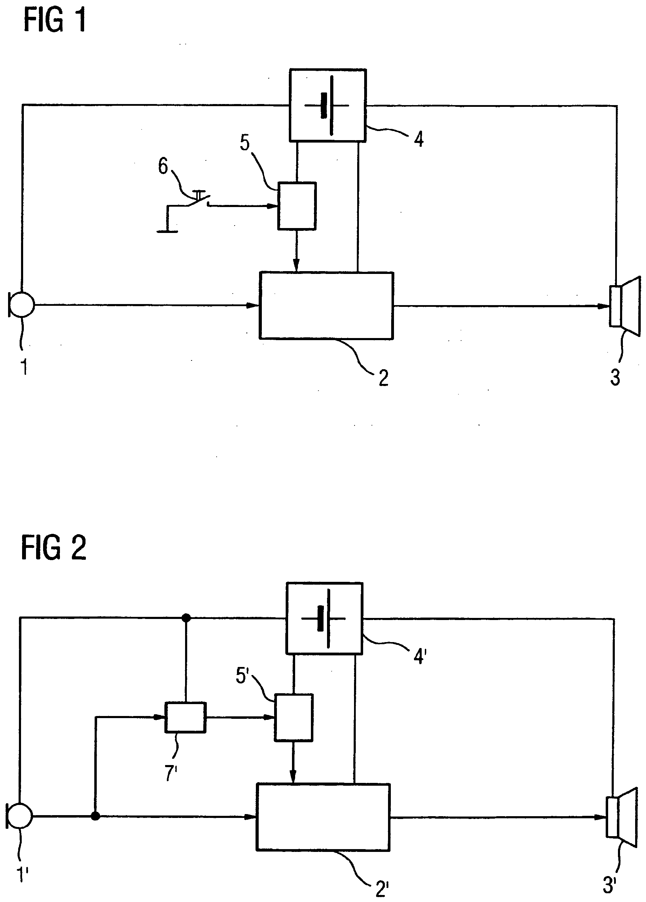

Figur 1 zeigt ein Hörhilfegerät mit einem Mikrofon 1 zur Aufnahme eines akustischen Eingangssignals und Wandlung in ein elektrisches Signal. Das elektrische Signal ist zur Weiterverarbeitung und frequenzabhängigen Verstärkung einer Signalverarbeitungseinheit 2 zugeführt. Das verarbeitete Signal wird schließlich durch den Hörer 3 in ein akustisches Signal gewandelt und dem Gehör eines Hörgeräteträgers zugeführt. Zur Spannungsversorgung des Mikrofons 1, der Signalverarbeitungseinheit 2 und des Hörers 3 ist eine Spannungsquelle in Form einer Batterie 4 vorgesehen. Ferner ist die Batterie 4 mit einer Auswerteeinheit 5 verbunden, durch die die zu erwartende Restlaufzeit des Hörhilfegerätes mit der Batterie 4 ermittelbar ist. Die Auswerteeinheit 5 wird insbesondere dann aktiv, wenn durch Betätigung des Tastschalters 6 manuell eine Abfrage der Restlaufzeit ausgelöst wird. Die Ermittlung der Restlaufzeit beruht beispielsweise auf einer Messung der Leerlaufspannung der Spannungsquelle, auf einer Messung der Ausgangsspannung der Spannungsquelle unter einer bestimmten Last oder durch eine kurzzeitige Messung des Kurzschlussstromes. Es können jedoch auch andere elektrische Größen, wie beispielsweise die Kapazität oder Induktivität der Spannungsquelle, gemessen werden. Vorzugsweise erfolgt die Ermittlung der Restlaufzeit unter Berücksichtigung mehrerer gemessener Größen. Darüber hinaus können auch nicht elektrische Größen, wie beispielsweise die Zeitdauer, in der sich die betreffende Spannungsquelle in dem Hörgerät befindet, oder die Betriebsdauer des Hörgerätes mit der betreffenden Spannungsquelle, die Ermittlung der Restlaufzeit bestimmen oder beeinflussen.

Die Auswerteeinheit 5 umfasst einen Signalgenerator zur Erzeugung eines für die Restlaufzeit charakteristischen Signals. Dieses Signal wird in den Signalpfad des Hörgerätes eingespeist, über den Hörer 3 in ein akustisches Signal gewandelt und dem Gehör des Hörgeräteträgers zugeführt.

Die Erfindung bietet den Vorteil, dass ein Hörgeräteträger jederzeit über . die zu erwartende Restlaufzeit des Hörhilfegerätes mit der betreffenden Spannungsquelle informierbar ist. Dadurch wird eine zur Neigung gehende Batterie frühzeitig erkannt und diese kann im Bedarfsfall rechtzeitig ausgewechselt werden. Als akustisches Ausgangssignal zur Information über die Restlaufzeit wird vorzugsweise ein Sinussignal mit steigender oder fallender Frequenz gewählt.

Bei einer anderen Ausführungsform der Erfindung wird von dem Signalgenerator ein Sprachsignal generiert, welches den Benutzer direkt über die Restlaufzeit informiert.

Ein weiteres Ausführungsbeispiel der Erfindung zeigt Figur 2. Dabei entsprechen die Komponenten 1', 2',3',4' und 5' den entsprechenden ungestrichenen Komponenten aus Figur 1. Im Unterschied zu dem Ausführungsbeispiel gemäß Figur 1 ist das Hörhilfegerät gemäß Figur 2 jedoch mit einer Analyseeinheit 7' ausgestattet, der das von dem Mikrofon 1' elektrische Eingangssignal zugeführt ist. Die Analyseeinheit 7' erkennt in dem akustischen Eingangssignal enthaltene Codewörter, durch die eine Steuerung des Hörhilfegerätes mittels Spracheingabe möglich ist. So kann beispielsweise das Codewort "Batterie-Check" die Information des Benutzers bezüglich der Restlaufzeit auslösen.

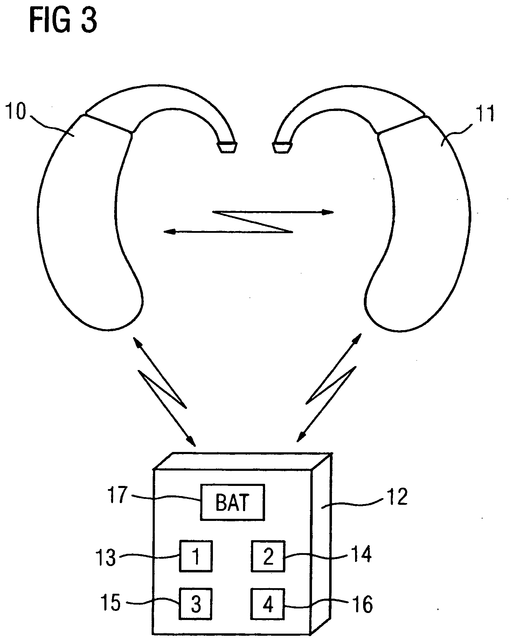

Aus dem Ausführungsbeispiel gemäß Figur 3 geht ein Hörgerätesystem mit einem ersten Hörhilfegerät 10 und einem zweiten Hörhilfegerät 11 zur binauralen Versorgung eines Hörgeräteträgers hervor. Ferner umfasst das Hörgerätesystem eine Fernbedienung 12 zur Bedienung der beiden Hörhilfegeräte 10 und 11. Zwischen der Fernbedienung 12 und den Hörhilfegeräten 10 und 11 sowie zwischen den Hörhilfegeräten 10 und 11 ist eine drahtlose Datenübertragung möglich. Durch Betätigung der Tasten 13, 14, 15 oder 16 an der Fernbedienung 12 können bei den Hörhilfegeräten 10 und 11 unterschiedliche Hörprogramme zur Anpassung an unterschiedliche Hörumgebungen eingestellt werden. Durch Betätigung der Taste 17 an der Fernbedienung 12 wird gemäß der Erfindung über die Restlaufzeit der beiden Hörhilfegeräte informiert. Die beiden Hörhilfegeräte 10 und 11 sind dabei so gesteuert, dass der Hörhilfegeräteträger zunächst über die Restlaufzeit des Hörhilfegerätes 10 informiert wird. Im Anschluss daran, sendet das Hörhilfegerät 10 ein Signal an das Hörhilfegerät 11, nach dessen Empfang auch dieses ein entsprechendes akustisches Signal zur Information bezüglich der Restlaufzeit ausgibt.

Von einer Beeinträchtigung des Hörvermögens eines Hörgeräteträgers sind nur in Ausnahmefällen beide Ohren gleichermaßen betroffen. Insofern werden die beiden Hörgeräte 10 und 11 bei einer binauralen Versorgung in der Regel mit unterschiedlichen Parametern betrieben. Dies bewirkt jedoch auch eine entsprechend unterschiedliche Stromaufnahme der beiden Hörhilfegeräte 10 und 11. Daher ist es auch nach einem gleichzeitigen Austausch der Spannungsquellen beider Hörhilfegeräte 10 und 11 sinnvoll, den Hörgeräteträger über die Restlaufzeit beider Hörhilfegeräte getrennt zu informieren.

## Patentansprüche

1. Hörhilfegerät mit einem Eingangswandler (1, 1') zur Aufnahme eines Eingangssignal und Wandlung in ein elektrisches Signal, einer Signalverarbeitungseinheit (2, 2') zur Verarbeitung und frequenzabhängigen Verstärkung des elektrischen Signals, einem Ausgangswandler (3, 3') zur Abgabe eines akustischen Ausgangssignals, einer Spannungsquelle (4, 4') zur Spannungsversorgung und mit Mitteln (6, 7', 12) zur Bedienung des Hörhilfegerätes, **dadurch gekennzeichnet, dass** durch die Bedienung des Hörhilfegerätes die zu erwartende Restlaufzeit des Hörhilfegerätes mit der verwendeten Spannungsquelle (4, 4') ermittelbar ist und von dem Hörhilfegerät ein die zu erwartende Restlaufzeit des Hörhilfegerätes kennzeichnendes akustisches Signal abgebbar ist, wobei Mittel zur Eingabe von Daten zur Kennzeichnung der verwendeten Spannungsquelle (4, 4') vorhanden sind und die Ermittlung der Restlaufzeit unter Berücksichtigung dieser Daten erfolgt.

2. Hörhilfegerät nach Anspruch 1, wobei die Bedienung durch Betätigung eines Bedienelementes (6, 13 bis 17) erfolgt.

3. Hörhilfegerät nach Anspruch 2, wobei das Bedienelement (17) an einer Fernbedienung (12) angeordnet ist.

4. Hörhilfegerät nach einem der Ansprüche 1 bis 3, wobei die Bedienung durch Abgabe eines akustischen Signals an das Hörhilfegerät und insbesondere durch Abgabe eines Sprachsignals erfolgt.

5. Hörhilfegerät nach einem der Ansprüche 1 bis 4, wobei die Bedienung zusätzlich das Ein- oder Ausschalten des Hörhilfegerätes bewirkt.

6. Hörhilfegerät nach einem der Ansprüche 1 bis 5, wobei bei einer ermittelten Restlaufzeit oberhalb eines bestimmten Schwellenwertes ein Ton mit steigender Frequenz ausgebbar ist, wobei die Dauer des Tons bzw. die Frequenzänderung ein Maß für die Abweichung von dem Schwellenwert ist.

7. Hörhilfegerät nach einem der Ansprüche 1 bis 6, wobei bei einer ermittelten Restlaufzeit unterhalb eines bestimmten Schwellenwertes ein Ton mit fallender Frequenz ausgebbar ist, wobei die Dauer des Tons bzw. die Frequenzänderung ein Maß für die Abweichung von dem Schwellenwert ist.

8. Hörhilfegerät nach einem der Ansprüche 1 bis 5, wobei von dem Hörhilfegerät ein Sprachsignal zur Kennzeichnung der Restlaufzeit abgebbar ist.

9. Hörgerätesystem mit einem ersten und einem zweiten Hörhilfegerät gemäß einem der Ansprüche 1 bis 8 zur binauralen Versorgung eines Hörgeräteträgers, wobei die beiden Hörhilfegeräte dazu ausgebildet sind, nach der Bedienung aufeinanderfolgend jeweils ein akustisches Signal zur Kennzeichnung der Restlaufzeit des jeweiligen Hörhilfegerätes abzugeben.

## Claims

1. Hearing aid with an input converter (1, 1') to accept an input signal and convert it into an electrical signal, a signal processing unit (2, 2') for processing and frequency-dependent amplification of the electrical signal, an output converter (3, 3') for emitting an acoustic output signal, a power source (4, 4') for power supply and with means (6, 7', 12) for operating the hearing aid, **characterised in that,** by operating the hearing aid, the expected remaining life of the hearing aid with the power source (4, 4') being used can be determined and the hearing aid is able to emit an acoustic signal indicating the expected remaining life of the hearing aid, whereby means are available for entering data to identify the power source (4, 4') being used and the remaining life is determined by taking account of this data.

2. Hearing aid in accordance with claim 1, with the hearing aid being operated by actuating an operating element (6, 13 to 17).

3. Hearing aid in accordance with claim 2, with the operating element (17) being arranged on a remote control (12).

4. Hearing aid in accordance with one of claims 1 to 3, with the hearing aid being operated by emitting an acoustic signal to the hearing aid and especially by emitting a voice signal.

5. Hearing aid in accordance with one of the claims 1 to 5, with the operation additionally effecting the switching on or off of the hearing aid.

6. Hearing aid in accordance with one of claims 1 to 5, with a tone with a rising frequency being able to be output if a remaining life above a specific threshold value is determined, with the duration of the tone or the frequency change being a measure of the deviation from the threshold value.

7. Hearing aid in accordance with one of claims 1 to 6, with a tone with a falling frequency being able to be output if a remaining life below a specific threshold value is determined, with the duration of the tone or the frequency change being a measure of the deviation from the threshold value.

8. Hearing aid in accordance with one of claims 1 to 5, with the hearing aid being able to emit a voice signal to indicate the remaining life.

9. Hearing aid system with a first and a second hearing aid according to one of claims 1 to 8, for binaural care of a hearing aid wearer, with the two hearing aids being embodied to each consecutively emit after operation an acoustic signal to indicate the remaining life of the relevant hearing aid.

## Revendications

1. Prothèse auditive comprenant un transducteur (1, 1') d'entrée pour la réception d'un signal d'entrée et sa transformation en un signal électrique, une unité (2, 2') de traitement de signal pour le traitement et l'amplification en fonction de la fréquence du signal électrique, un transducteur (3, 3') de sortie pour l'émission d'un signal acoustique de sortie, une source (4, 4') de tension pour l'alimentation en tension et des moyens (6, 7', 12) pour la commande de la prothèse auditive, **caractérisée en ce que,** par la commande de la prothèse auditive, le temps restant à courir auquel on peut s'attendre de la prothèse auditive peut être déterminé avec la source (4, 4') de tension utilisée, et un signal acoustique, caractérisant le temps restant à courir auquel on peut s'attendre de la prothèse auditive, peut être émis par la prothèse auditive, des moyens d'entrée de données pour la caractérisation de la source (4, 4') de tension utilisée étant présents et la détermination du temps restant à courir s'effectuant en tenant compte de ces données.

2. Prothèse auditive suivant la revendication 1, dans laquelle la commande s'effectue par actionnement d'un élément (6, 13 à 17) de commande.

3. Prothèse auditive suivant la revendication 2, dans laquelle l'élément (17) de commande est mis sur une télécommande (12).

4. Prothèse auditive suivant l'une des revendications 1 à 3, dans laquelle la commande s'effectue par émission d'un signal acoustique à la prothèse auditive et notamment par émission d'un signal vocal.

5. Prothèse auditive suivant l'une des revendications 1 à 4, dans laquelle la commande provoque supplémentairement la mise en circuit ou hors circuit de la prothèse auditive.

6. Prothèse auditive suivant l'une des revendications 1 à 5, dans laquelle, pour un temps restant à courir déterminé au-dessus d'une valeur de seuil déterminé, une tonalité d'une fréquence croissante peut être émise, la durée de la tonalité ou la variation de fréquence représentant une mesure de l'écart à la valeur de seuil.

7. Prothèse auditive suivant l'une des revendications 1 à 6, dans laquelle, pour un temps restant à courir déterminé au-dessous d'une valeur de seuil déterminé, une tonalité de fréquence décroissante peut être émise, la durée de la tonalité ou la variation de fréquence représentant une mesure de l'écart à la valeur de seuil.

8. Prothèse auditive suivant l'une des revendications 1 à 5, dans laquelle, un signal vocal de caractérisation du temps restant à courir peut être émis par la prothèse auditive.

9. Système de prothèse auditive comprenant une première et une deuxième prothèses auditives suivant l'une des revendications 1 à 8 pour l'alimentation binaurale d'un porteur de prothèse auditive, les deux prothèses auditives étant constituées de manière à ce qu'après la commande, successivement respectivement un signal acoustique de caractérisation du temps restant à courir de chaque prothèse auditive soit émis.
